# EUROPÄISCHE PATENTSCHRIFT

(11) **EP 4 038 736 B1**
(45) Veröffentlichungstag und Bekanntmachung des Hinweises auf die Patenterteilung: **26.06.2024**
(21) Anmeldenummer: 20793563.6
(22) Anmeldetag: 02.10.2020
(51) Int. Cl.: H02N 2/10, H02N 2/12

(54) **ROTATIONSSTELLVORRICHTUNG UND VERFAHREN ZUM BETREIBEN EINER SOLCHEN ROTATIONSSTELLVORRICHTUNG**
ROTARY ACTUATOR AND METHOD OF OPERATING SUCH ROTARY ACTUATOR
UN ACTIONNEUR ROTATIF ET PROCEDE D'UTILISATION DE CET ACTIONNEUR ROTATIF

(30) Priorität: 02.10.2019 DE 102019126702
(43) Veröffentlichungstag der Anmeldung: 10.08.2022
(73) Patentinhaber: Physik Instrumente (PI) GmbH & Co. KG, 76228 Karlsruhe (DE)
(72) Erfinder: BOCSKAI, Dominik, 76473 Iffezheim (DE); MARTH, Harry, 76337 Waldbronn (DE)
(74) Vertreter: Keller Schneider Patentanwaltsgesellschaft mbH
(86) Internationale Anmeldenummer: PCT/DE2020/100854
(87) Internationale Veröffentlichungsnummer: WO 2021/063454

(56) Entgegenhaltungen:
- WO-A1-2017/158017
- US-A- 4 613 782
- US-A1- 2004 178 699

## Beschreibung

Die Erfindung betrifft eine Rotationsstellvorrichtung gemäß Anspruch 1. Die Erfindung betrifft zudem ein Verfahren zum Betreiben einer solchen Rotationsstellvorrichtung gemäß Anspruch 9.

Die auf die Anmelderin zurückgehende WO2017/158017 A1 beschreibt in dortigen Figur 7 eine Rotationsstellvorrichtung unter Verwendung eines piezoelektrischen Schreitantriebs 1 mit einer Antriebsvorrichtung 2, bei der mit Bezug auf Figur 2 dieser Druckschrift vier piezoelektrische Aktoren 213, 214, 223, 224 paarweise in V-förmiger Anordnung zueinander in einem Rahmen 20 eingesetzt sind. Jedes Paar der V-förmig zueinander angeordneten Aktoren ist mittels eines zugehörigen Antriebsabschnitts 21, 22 und eines zwischen dem Antriebsabschnitt und der Basis 201 des Rahmens 20 angeordneten elastischen Federabschnitts 211, 221 gegen Festkörpergelenke 212, 222 der Basis 201 gedrückt, wodurch insbesondere eine Vorspannkraft auf die Aktoren realisiert ist.

Durch Anordnung der Antriebsvorrichtung 2 an einem Grundrahmen 4 mit elastisch verformbaren Abschnitten in Form von Festkörpergelenken (in. Figur 7 der WO2017/158017 A1 nicht gezeigt) gelingt einerseits ein Anpressen der Antriebsabschnitte gegen den Läufer 3 in Form einer kreisrunden Scheibe; andererseits erlauben die elastischen Eigenschaften des Rahmens, dass bei Ansteuerung eines zusammenwirkenden Aktorpaars und der entsprechenden Bewegung des mit diesem gekoppelten Antriebsabschnitts der Antriebsabschnitt des anderen zusammenwirkenden Aktorpaars entweder ausschließlich passiv, d.h. ohne elektrische Ansteuerung und nur aufgrund der mechanischen Anordnung bzw. Gegebenheiten, von dem Läufer abhebt, oder aber zusätzlich aktiv, d.h. durch entsprechende elektrische Ansteuerung des betreffenden Aktorpaars, welche das Abheben dieses Antriebsabschnitts von dem Läufer unterstützt bzw. verbessert.

Nachteilig bei der gemäß Figur 7 der WO2017/158017 A1 offenbarten Rotationsstellvorrichtung ist deren vergleichsweise großer Platzbedarf, insbesondere bei Verwendung mehrerer um den Außenumfang des Läufers angeordneter Antriebsvorrichtungen 2.

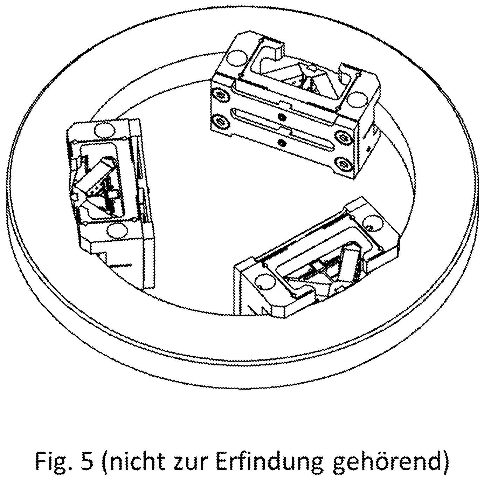

Zur Lösung des vorgenannten Problems wäre es gemäß Figur 5 vorliegender Anmeldung, welche nicht Gegenstand der Erfindung ist, etwa denkbar, drei Antriebsvorrichtungen gemäß der WO2017/158017 A1 am Innenumfang eines als Ringscheibe ausgeführten Läufers anzuordnen, wobei diesbezüglich auch die Verwendung von lediglich einer Antriebsvorrichtung oder von zwei oder mehr als drei Antriebsvorrichtungen möglich ist. Durch diese Art der Anordnung der Antriebsvorrichtung bzw. Antriebsvorrichtungen, die zusätzlich das passive Abheben des Antriebsabschnitts des nicht angesteuerten Aktorpaars einer Antriebsvorrichtung begünstigt, könnte eine relativ klein bauende Rotationsstellvorrichtung mit geringer Stellfläche realisiert werden. Nachteilig wäre jedoch die vergleichsweise aufwändige Herstellung des Läufers bzw. die Bearbeitung der Innenumfangsfläche, da diese für einen Antrieb mit hoher Präzision sehr genau und unter Einhaltung geringer Toleranzen gefertigt sein muss. Zudem ist bei einer solchen Lösung ein hoher Aufwand hinsichtlich der Ausrichtung des Läufers bzw. dessen Rotationsachse notwendig.

Die US 4,613,782 offenbart in deren Figuren 3 und 4 eine Rotationsstellvorrichtung mit drei Antriebseinheiten umfassend jeweils zwei V-förmig zueinander angeordnete piezoelektrische Aktoren 1 und 2, die sich mit einem ihrer Endabschnitte an einer gemeinsamen Basis 17 abstützen und an den gegenüberliegenden Endabschnitten über einen Bewegungsmechanismus 18 gekoppelt sind, wobei der Bewegungsmechanismus 18 ein Antriebselement 10 aufweist, welches über eine mit der Basis 17 verbundene Schraube gegen den Bewegungsmechanismus 18 gedrückt ist und daraus resultierend über den Bewegungsmechanismus eine Druckkraft bzw. Vorspannkraft auf die Aktoren 1 und 2 ausgeübt wird.

Die drei Antriebseinheiten sind gleichmäßig zu einem Umfang des als Ringscheibe ausgeführten angetriebenen Elements 11 angeordnet, so dass die drei Antriebselemente 10 einen Umfangswinkelabstand von ca. 120° zueinander besitzen. Da diese zwischen einer Basis und dem angetriebenen Element angeordnet sind, sind die äußeren Abmessungen der Rotationsstellvorrichtung im Wesentlichen durch die feststehende Wand 20 bzw. das Gehäuse 28 definiert.

Im Betrieb werden die Aktoren der Antriebseinheiten derart elektrisch angesteuert, dass die mit den Aktoren gekoppelten Antriebselemente 10 hochfrequente Schwingungen mit einer ellipsenförmigen Bewegungsbahn vollführen, wobei die Frequenz dieser Schwingungen gemäß Spalte 9, Zeile 13 der US 4,613,782 bei 20kHz, also im Ultraschallbereich, liegt. Dabei werden alle drei Antriebseinheiten mit dem gleichen hochfrequenten Spannungssignal beaufschlagt, so dass diese synchron arbeiten.

Aus der synchronen Ansteuerung der drei Antriebseinheiten resultieren zeitliche Phasen, in denen keine der drei Antriebseinheiten Kontakt mit dem angetriebenen Element 11 hat, so dass in diesen Phasen eine Unterbrechung des Antriebs stattfindet. Die zeitlichen Phasen der Unterbrechung des Antriebs sind bei hohen Ansteuerfrequenzen der Aktoren der Antriebseinheiten, d.h. bei hohen Rotationsgeschwindigkeiten des angetriebenen Elements, nur sehr kurz und können in diesem Geschwindigkeitsregime akzeptabel sein. Je niedriger jedoch die Ansteuerfrequenzen bzw. je niedriger die Rotationsgeschwindigkeiten sind, umso mehr machen sich die Antriebsunterbrechungen bemerkbar, weshalb die aus der US 4,613,782 bekannten Rotationsstellvorrichtungen für bestimmte Anwendungsfälle ausscheiden. Das Dokument US2004178699 offenbart einen herkömmlichen Aktuator 700, wo die piezoelektrischen Elemente 101 und 102 mit unterschiedlichen Phasen angesteuert werden, so dass das Spitzenelement 103 an der Stelle, an der die piezoelektrischen Elemente 101 und 102 zusammentreffen, zu einer Bewegung auf einer vorbestimmten elliptischen Bahn angeregt wird. Das Basiselement 104 besteht aus elastischem Material, so dass die Schwingung oder Oszillation eines der piezoelektrischen Elemente 101 und 102 durch das Basiselement 104 auf das andere der piezoelektrischen Elemente 101 und 102 übertragen wird.

Vor dem skizzierten Hintergrund ist es Aufgabe der Erfindung, eine Rotationsstellvorrichtung bereitzustellen, welche bei kompakten Abmessungen hochpräzise und unterbrechungsfreie Stellbewegungen ermöglicht.

Diese Aufgabe wird gelöst durch eine Rotationsstellvorrichtung nach Anspruch 1. Diese weist wenigstens vier Antriebseinheiten auf, die zwischen einer Basis und einem Rotor umfangsartig an der Basis angeordnet sind. Die Antriebseinheiten lassen sich einer ersten und einer zweiten Gruppe zuordnen, so dass jede der beiden Gruppen wenigstens zwei Antriebseinheiten aufweist. Es ist im Sinne der Erfindung, dass jede der Gruppen mehr als zwei Antriebseinheiten aufweist, wobei bevorzugt jede Gruppe drei Antriebseinheiten aufweist.

Jede der Antriebseinheiten umfasst zwei Aktoren, die V-förmig zueinander angeordnet sind, wobei der Bereich der Spitze des so gebildeten V durch ein Friktionselement realisiert ist, welches die beiden Aktoren miteinander verbindet bzw. miteinander koppelt. Die Spitze des V und somit das Friktionselement ist dem Rotor der Rotationsstellvorrichtung zugewandt.

Der von den beiden Aktoren einer Antriebseinheit aufgrund der V-förmigen Anordnung zwischen diesen eingeschlossene Winkel kann in einem weiten Bereich variieren. Hierbei sind Winkel zwischen 10° und 160° möglich. Bevorzugt ist hierbei jedoch ein Winkelbereich zwischen 55° und 125°, wobei der Winkelbereich 85° bis 95° besonders bevorzugt ist.

Die Friktionselemente der Antriebseinheiten und der Rotor sind mittels einer zentral und zwischen den Antriebseinheiten angeordneten Federeinrichtung derart in einer Richtung aufeinander zu gedrückt, dass in einem nicht-angesteuerten bzw. unausgelenkten Zustand der Aktoren sämtliche Friktionselemente in Kontakt mit dem Rotor stehen. Hierbei spannen die entsprechenden Kontaktpunkte bzw. Kontaktflächen gemeinsam eine Kontaktebene K auf. Die zentrale Anordnung der Federeinrichtung, bei welcher die Antriebseinheiten die Federeinrichtung umfangsartig umgeben, ermöglicht einen besonders kompakten Aufbau der Rotationsstellvorrichtung.

Es kann es von Vorteil sein, dass die Federeinrichtung einstückig mit dem Rotor ausgebildet ist. Aufgrund einer einstückigen oder integralen Ausführung der Federeinrichtung mit dem Rotor gelingt eine einfachere Struktur der Rotationsstellvorrichtung mit verbesserten Montageeigenschaften. Hierbei kann es von besonderem Vorteil sein, dass die Federeinrichtung schlitzförmige Ausnehmungen aufweist, über welche die Federwirkung der Federeinrichtung erzielt wird.

Daneben kann es vorteilhaft sein, dass sich die Aktoren an der Basis jeweils an einem Stützabschnitt, der über ein Gelenk bzw. einen Gelenkabschnitt mit der Basis verbunden ist, abstützen. Vorzugsweise sind der Stützabschnitt und das Gelenk bzw. der Gelenkabschnitt einstückig bzw. integral mit der Basis ausgebildet. Durch die Abstützung an gelenkig angeordneten Stützabschnitten kann einer Belastung der Aktoren mit Querkräften entgegengewirkt werden. Zudem können darüber mechanische Toleranzen, die aus der Fertigung oder der Montage resultieren, ausgeglichen werden.

Außerdem kann es von Vorteil sein, dass die Aktoren ein elektromechanisches Material aufweisen und vorzugsweise daraus bestehen. Ein elektromechanisches Material vollführt bei Anlegen einer elektrischen Spannung und entsprechender Ausbildung eines elektrischen Feldes eine mechanische Deformation, die zu Stell- oder Antriebsbewegungen nutzbar ist. Aktoren aus einem elektromechanischen Material weisen keine mechanischen Bauteile auf und können elektrische Energie sehr effizient und mit sehr hoher Dynamik in eine mechanische Deformation bzw. Bewegung umsetzen. Es ist ebenso denkbar, dass die Aktoren ein elektrostriktive Eigenschaften aufweisendes Material umfassen bzw. aus diesem bestehen.

Bevorzugt bestehen die Aktoren aus einem piezoelektrischen Material und besonders bevorzugt aus einem piezokeramischen Material. Piezoelektrische bzw. piezokeramische Materialien sind gut verfügbar und können sehr definiert betrieben werden. Denkbar ist ebenfalls, dass die Aktoren ein Material mit elektrostriktiven Eigenschaften aufweisen.

Die Erfindung umfasst zudem ein Verfahren zum Betreiben einer vorstehend beschriebenen Rotationsstellvorrichtung, bei dem unterschiedliche Gruppen von Antriebseinheiten phasenversetzt zueinander angesteuert werden. Etwa werden bei einer Rotationsstellvorrichtung mit zwei Gruppen von Antriebseinheiten die Antriebseinheiten einer ersten Gruppe phasenversetzt zu den Antriebseinheiten der entsprechenden zweiten Gruppe angesteuert.

Hierbei kann es von Vorteil sein, dass die Ansteuerung der jeweiligen Gruppe von Antriebseinheiten derart erfolgt, dass eine definierte Bewegungsbahn der diesen Antriebseinheiten zugeordneten Friktionselemente resultiert, die eine im Wesentlichen senkrecht zur Kontaktebene K angeordnete vertikale Bewegungskomponente und eine im Wesentlichen parallel zur Kontaktebene K angeordnete horizontale Bewegungskomponente aufweist, und aufgrund der vertikalen Bewegungskomponente, die gegen die Kraft der Federeinrichtung wirkt, ein Außerkontaktbringen der Friktionselemente der Aktoren der jeweils anderen Gruppe von Antriebseinheiten von dem Rotor und aufgrund der horizontalen Bewegungskomponente eine Generierung eines definierten Antriebsschritts des Rotors in Antriebsrichtung resultiert.

Es folgt die Beschreibung einer Ausführungsform der erfindungsgemäßen Rotationsstellvorrichtung mit Hinblick auf die entsprechenden Figuren, wobei sich gleiche Bezugszeichen auf gleiche Teile der unterschiedlichen Figuren beziehen.
Fig. 1: Perspektivische Darstellung einer erfindungsgemäßen Rotationsstellvorrichtung
Fig. 2: Perspektivische Darstellung der Rotationsstellvorrichtung gemäß Fig. 1 in anderer Ansicht
Figuren 3A und 3B: Draufsicht und Schnittdarstellung bezüglich der Rotationsstellvorrichtung gemäß Fig. 1 bzw. Fig. 2
Figuren 4A und 4B: Schematische Darstellung betreffend die Gruppen von Antriebseinheiten der erfindungsgemäßen Rotationsstellvorrichtung
Fig. 5: Perspektivische Darstellung einer nicht zur Erfindung gehöhrenden Rotationsstellvorrichtung

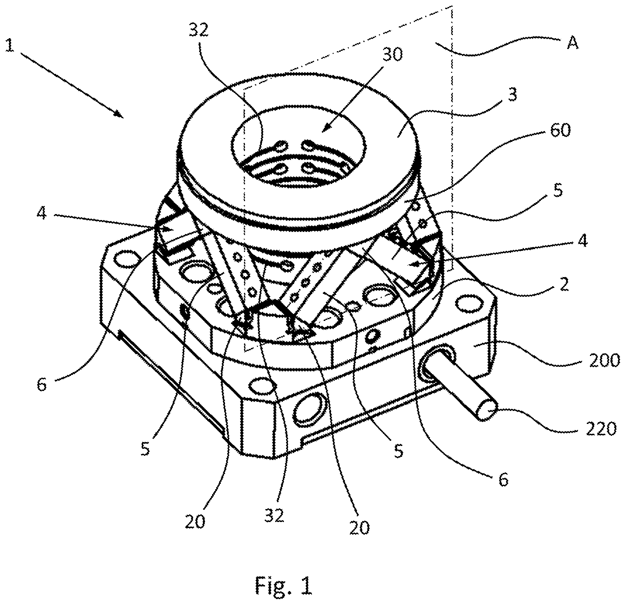

Figur 1 zeigt eine erfindungsgemäße Rotationsstellvorrichtung 1 in perspektivischer Darstellung. An einer im Wesentlichen ringförmig ausgebildeten Basis 2 aus Edelstahl, welche mit einem Sockel 200 verbunden ist, sind umfangsartig und im Wesentlichen 90° versetzt zueinander insgesamt vier Antriebseinheiten 4 derart angeordnet, dass sich diese paarweise diametral und in Überdeckung zueinander gegenüberliegen.

Jede Antriebseinheit 4 ist gebildet durch zwei langgestreckte piezoelektrische Aktoren 5, die derart zueinander angeordnet sind, dass sie gemeinsam im Wesentlichen eine V-Form bilden, wobei die von der Basis 2 weg weisenden Enden der beiden Aktoren 5 einer Antriebseinheit 4 über ein im Wesentlichen dreiecksförmiges Friktionselement 6 miteinander verbunden bzw. gekoppelt sind. Das jeweilige andere Ende jedes Aktors 5 einer Antriebseinheit 4, welches zu der Basis 2 hin weist, stützt sich an einem Stützabschnitt 20 ab, der über ein Festkörpergelenk mit der Basis 2 verbunden ist. Stützabschnitt 20 und Festkörpergelenk sind dabei einstückig bzw. integral mit der Basis 2 ausgebildet.

Die Mittelebenen der beiden einer Antriebseinheit 4 zugeordneten und V-förmig zueinander angeordneten Aktoren 5 spannen eine Ebene auf, welche eine Antriebseinheitenmittelebene A definiert, wobei die Antriebseinheitenmittelebenen A der paarweise diametral gegenüberliegend angeordneten Antriebseinheiten 4 im Wesentlichen parallel zueinander liegen, und die Antriebseinheitenmittelebenen A benachbarter Antriebseinheiten 4 im Wesentlichen senkrecht zueinander angeordnet sind.

Die säulenförmig ausgebildeten piezoelektrischen Aktoren bestehen aus einem piezokeramischen Material. Sie sind jeweils sowohl mit dem zugeordneten Gelenk 20, als auch mit dem zugeordneten Friktionselement 6 stoffschlüssig, insbesondere durch Kleben, verbunden. Die beiden einer Antriebseinheit 4 zugehörigen Aktoren 5 schließen zwischen sich einen Winkel von etwa 90° ein.

Im in Fig. 1 dargestellten Ruhezustand der Rotationsstellvorrichtung, bei welchem keiner der Aktoren 5 der vier Antriebseinheiten 4 elektrisch angesteuert bzw. mit einer elektrischen Spannung beaufschlagt ist, befinden sich alle vier Friktionselemente 6 in Kontakt mit einer ringförmigen Friktionsscheibe 60, welche mit einem Rotor 3 stoffschlüssig verbunden ist.

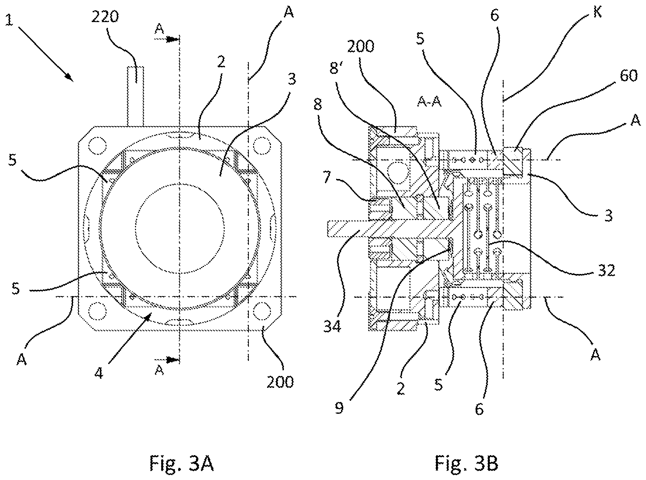

Die Friktionsscheibe 60 ist im Wesentlichen parallel zu der Basis 2 und beanstandet zu dieser angeordnet, wobei die Antriebseinheiten 4 zwischen der Basis 2 und der Friktionsscheibe 60 gelegen sind. Die Kontaktpunkte bzw. Kontaktflächen der Friktionselemente 6 mit der Friktionsscheibe 60 liegen im Wesentlichen in einer Kontaktebene K (siehe Figur 3B), wobei die Antriebseinheitenmittelebenen A im Wesentlichen senkrecht zu der Kontaktebene K angeordnet sind.

Der Sockel 200 dient der Aufnahme der zu den Aktoren 5 der Antriebseinheiten 4 führenden Kabel, mit denen die elektrische Spannungsversorgung der Aktoren 5 gewährleistet ist. Diese innenliegenden Kabel sind mit der Zuleitung 220 verbunden. Der Sockel 200 dient weiterhin der Montage der Rotationsstellvorrichtung an einer übergeordneten Einheit. Es ist denkbar, in den Sockel 200 elektronische Bauteile zur Regelung der Rotationsstellvorrichtung 1, etwa Sensoren, Empfänger, Controller, Treiber, etc. zu integrieren. Zudem ist denkbar, in dem Sockel 200 eine Batterie oder einen Akkumulator zur unabhängigen energetischen Versorgung der Rotationsstellvorrichtung vorzusehen.

Der Rotor 3 ist drehbar gegenüber der feststehenden Basis 2 gelagert. Integral bzw. einstückig mit dem Rotor ist an dessen Innenumfang eine Federeinrichtung 30 ausgebildet, wobei die Federeinrichtung 30 zentral und zwischen den Antriebseinheiten 4 gelegen ist, so dass die Antriebseinheiten 4 die Federeinrichtung 30 umfangsartig umgeben oder umrahmen. Die federnde Wirkung der Federeinrichtung 30 ist hierbei durch schlitzförmige, in Umfangsrichtung des Rotors 3 weisende und in Axialrichtung des Rotors 3 beabstandete Ausnehmungen 32 realisiert. Die Federeinrichtung 30 des Rotors 3 bewirkt, dass der Rotor 3 bzw. die Friktionsscheibe 60 elastisch gegen alle Friktionselemente 6 der Antriebseinheiten 4 gedrückt ist.

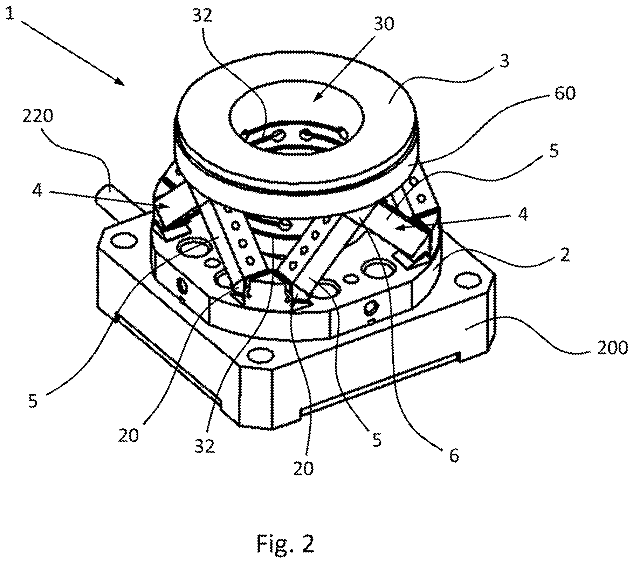

Figur 2 zeigt die Rotationsstellvorrichtung 1 gemäß Figur 1 in anderer Ansicht, wobei hier die in Figur 1 verdeckte Rückseite zu sehen ist und somit die dort angeordnete und in Figur 1 nicht zu erkennende Antriebseinheit 4. Da in Figur 2 ansonsten keine Merkmale zu erkennen sind, die nicht bereits Figur 1 entnehmbar sind, wird an dieser Stelle auf eine eingehendere Beschreibung von Figur 2 verzichtet.

Figur 3A zeigt die erfindungsgemäße Rotationsstellvorrichtung gemäß Figur 1 bzw. Figur 2 in einer Draufsicht (Blickrichtung senkrecht zu der Basis 2 bzw. dem Rotor 3), während sich Figur 3B auf den in Figur 3A gekennzeichneten Schnitt bezieht. In der Schnittdarstellung gemäß Figur 3B ist gut zu erkennen, dass im hier gezeigten Ruhezustand, in welchem keine elektrische Ansteuerung der Aktoren der Antriebseinheiten vorliegt, die beiden erkennbaren Friktionselemente 6 in Kontakt mit der Friktionsscheibe 60 stehen, und dies ebenso für die beiden weiteren und in Figur 3B nicht erkennbaren Friktionselemente 6 gilt. Die resultierenden vier Kontaktpunkte bzw. Kontaktflächen zwischen den Friktionselementen 6 und der Friktionsscheibe 60 liegen im Wesentlichen in einer Ebene, welche die Kontaktebene K definiert. Im Wesentlichen senkrecht zu der Kontaktebene K sind die Antriebseinheitenmittelebenen A angeordnet, wobei die Antriebseinheitenmittelebenen A diametral gegenüberliegender Antriebseinheiten 4 im Wesentlichen parallel zueinander angeordnet sind.

Weiterhin ist Figur 3B zu entnehmen, dass einstückig mit dem Rotor 3 ein Schaft 34 ausgebildet ist, der sowohl durch die Basis 2, als auch durch den Sockel 200 hindurchragt und gegenüber der Oberfläche des Sockels 200 übersteht, so dass an dem überstehenden Abschnitt des Schafts 34 ein durch die Rotationsstellvorrichtung 1 zu positionierendes Element anbringbar bzw. damit verbindbar ist.

Zur Einstellung der Federkraft, mit welcher der Rotor 3 bzw. die Friktionsscheibe 60 elastisch gegen die Friktionselemente 6 der Antriebseinheiten 4 gedrückt ist, dient eine Spannmutter 7, welche an einem entsprechenden Gewindeabschnitt des Schafts 34 angreift und sich an einem Lager 8 abstützt. Durch Aufdrehen der Spannmutter 7 auf den Gewindeabschnitt des Schafts 34 wird der Schaft 34 und damit der Rotor 3 in Richtung der Spannmutter 7 (in Fig. 3B also nach links) gezogen, so dass über den Rotor 3 die damit verbundene Friktionsscheibe 60 elastisch gegen die Friktionselemente 6 der Antriebseinheiten 4 gedrückt ist.

Bei dem Lager 8 handelt es sich um ein Schrägkugellager, das durch die auf den Gewindeabschnitt des Schafts 34 aufgedrehte Spannmutter 7 vorgespannt ist. Ein zweites Schrägkugellager 8' ist von dem ersten Schrägkugellager 8 durch einen Sprengring getrennt, und ist durch eine zwischen dem Rotor 3 und diesem vorgesehene Tellerfeder 9 vorgespannt.

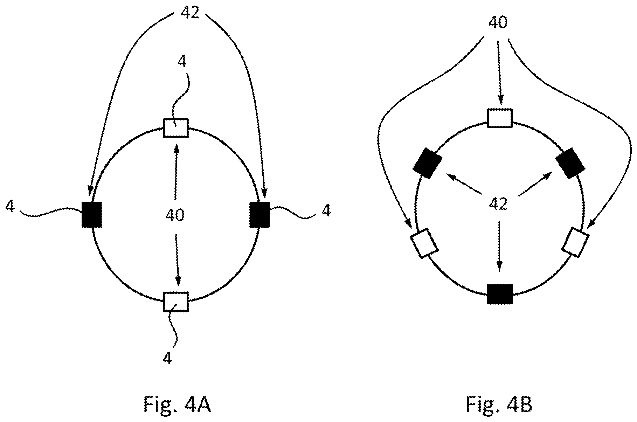

Die Figuren 4A und 4B verdeutlichen schematisch zwei mögliche Anordnungsvarianten bezüglich der Antriebseinheiten 4. Figur 4A entspricht hierbei der Anordnung von Antriebseinheiten 4 gemäß dem Ausführungsbeispiel für eine erfindungsgemäße Rotationsstellvorrichtung nach den Figuren 1 bis 3, wobei vier Antriebseinheiten 4 entlang eines Kreisumfangs mit einem jeweiligen Winkelabstand zueinander von im Wesentlichen 90° angeordnet sind. Auf diese Weise sind jeweils zwei Antriebseinheiten diametral gegenüberliegend angeordnet, wobei das entsprechende Paar von Antriebseinheiten 4 einer Gruppe zuordenbar ist. In Figur 4A bildet das Paar von Antriebseinheiten 4, welches durch einen unausgefüllten Rahmen gekennzeichnet ist, eine erste Gruppe 40 von Antriebseinheiten 4, während das andere Paar von Antriebseinheiten 4, welches durch einen ausgefüllten Rahmen gekennzeichnet ist, eine zweite Gruppe 42 von Antriebseinheiten 4.

Bei einem erfindungsgemäßen Verfahren zum Betreiben einer entsprechenden Rotationsstellvorrichtung gemäß den Figuren 1 bis 3 werden die beiden Gruppen 40 und 42 von Antriebseinheiten 4 bzw. deren Aktoren 5 phasenversetzt, bevorzugt um einen Phasenversatz von 180°, elektrisch angesteuert. Die Ansteuersignale führen bei der jeweiligen Antriebseinheit 4 bevorzugt zu einer elliptischen Bewegungsbahn des der Antriebseinheit 4 zugeordneten Friktionselements 6, wobei die Friktionselemente 6 der einer Gruppe 40, 42 zugeordneten Antriebseinheiten 4 eine simultane Bewegungsbahn vollführen. Auf diese Weise bewirkt etwa zunächst die Gruppe 40 von Antriebseinheiten einen definierten rotatorischen Vorschub- oder Stellbewegungsschritt des Rotors 3, und unmittelbar nachfolgend, d.h. nachdem die Antriebseinheiten 4 der Gruppe 40 ihren Vorschubschritt beendet haben, die Gruppe 42 von Antriebseinheiten 4 einen solchen Vorschub- oder Stellbewegungsschritt. Die Gruppen 40, 42 von Antriebseinheiten 4 führen demnach abwechselnd einen definierten Vorschubschritt aus, wobei hierbei auch ein gewisser Überlapp in den Antriebsbewegungen möglich ist, d.h. dass eine Gruppe von Antriebseinheiten bereits den nächsten Vorschubschritt startet, während die andere Gruppe von Antriebseinheiten deren Vorschubschritt noch nicht vollständig beendet hat.

Aufgrund der Form der Bewegungsbahn der Friktionselemente 6 der Antriebseinheiten 4, welche bevorzugt elliptisch ist und damit sowohl horizontale Bewegungskomponenten im Wesentlichen parallel zu der Kontaktebene K als auch vertikale Bewegungskomponenten im Wesentlichen senkrecht zu der Kontaktebene K und im Wesentlichen parallel zu den Antriebseinheitenmittelebenen A aufweist, bewirkt die Antriebsbewegung einer Gruppe 40, 42 von Antriebseinheiten 4 bzw. bewirken die vertikalen Bewegungskomponenten des jeweiligen Friktionselements 6 eine Kraft auf die Federeinrichtung 30 des Rotors 3, welche der von dieser ausgeübten Federkraft, die für eine Bewegung des Rotors 3 bzw. der Friktionsscheibe 60 in Richtung auf die Friktionselemente 6 zu und damit für ein Anpressen der Friktionselemente 6 an die Friktionsscheibe 60 sorgt, entgegenwirkt und somit auf rein mechanische oder passive Weise ein Abheben bzw. Außerkontaktbringen der Friktionselemente 6 der jeweiligen anderen und nicht zum Vortrieb genutzten Gruppe von Antriebseinheiten 4 resultiert. Somit ist gewährleistet, dass während eines Vorschubschritts - realisiert durch eine Gruppe von Antriebseinheiten 4 bzw. durch die horizontalen Komponenten der Bewegungsbahnen der diesen zugeordneten Friktionselemente - die Friktionselemente der Antriebseinheiten 4 der jeweils anderen Gruppe diesen Vorschubschritt nicht durch deren Kontakt mit der Friktionsscheibe 60 des Rotors 3 behindern.

Es kann vorteilhaft sein, dass der zuvor beschriebene Vorgang des mechanisch bedingten Abhebens der Friktionselemente einer Gruppe von Antriebseinheiten unterstützt wird durch eine entsprechende elektrische Ansteuerung der Aktoren dieser Gruppe von Antriebseinheiten, bei welcher dieser eine gewisse Längenreduktion erfahren.

Gemäß Figur 4B ist denkbar, dass eine Gruppe 40, 42 von Antriebseinheiten drei Antriebseinheiten 4 umfasst, und die insgesamt sechs Antriebseinheiten entlang eines Kreisumfangs angeordnet sind, wobei zwischen benachbarten Antriebseinheiten ein Winkelabstand von ca. 60° besteht. Hierbei ist stets eine Antriebseinheit einer Gruppe zwischen zwei Antriebseinheiten der anderen Gruppe angeordnet, so dass die Antriebseinheiten einer Gruppe einen Winkelabstand von ca. 120° zueinander einnehmen. Der spezifische Vorteil bei Verwendung von zwei Gruppen von Antriebseinheiten zu je drei Antriebseinheiten resultiert aus einem verbesserten mechanisch bedingten Abheben der Friktionselemente der nicht zum Vortrieb genutzten Antriebseinheiten während des durch die Antriebseinheiten der anderen Gruppe bewirkten Vorschubschritts.

Neben den beiden in den Figuren 4A und 4B dargestellten Anordnungen der Antriebseinheiten sind weitere Konfigurationen möglich, bei denen jede der beiden Gruppen von Antriebseinheiten mehr als drei Antriebseinheiten umfasst. Denkbar ist zudem das Vorsehen von mehr als zwei Gruppen von Antriebseinheiten, wobei die Antriebseinheiten der einzelnen Gruppen phasenversetzt zueinander erfolgt. Beispielsweise können die sechs Antriebseinheiten der Konfiguration gemäß Figur 4B drei Gruppen von jeweils diametral gegenüberliegenden Antriebseinheiten zugeordnet werden, und die drei Gruppen von Antriebseinheiten umfangsartig nacheinander angesteuert werden.

### Bezugszeichenliste:

- 1:: Rotationsstellvorrichtung
- 2:: Basis
- 3:: Rotor
- 4:: Antriebseinheit
- 5:: Aktor (der Antriebseinheit 4)
- 6:: Friktionselement (der Antriebseinheit 4)
- 7:: Spannmutter
- 8, 8`:: Schrägkugellager
- 9:: Tellerfeder
- 20:: Stützabschnitt
- 30:: Federeinrichtung
- 32:: schlitzförmige Ausnehmungen (der Federeinrichtung 30)
- 34:: Schaft (des Rotors 3)
- 40:: erste Gruppe von Antriebseinheiten 4
- 42:: zweite Gruppe von Antriebseinheiten 4
- 60:: Friktionsscheibe
- 200:: Sockel
- 220:: elektrische Zuleitung
- A:: Antriebseinheitenmittelebene
- K:: Kontaktebene

## Patentansprüche

1. Rotationsstellvorrichtung (1) mit:
einer Basis (2),
einem Rotor (3), und
wenigstens zwei Gruppen (40, 42) von Antriebseinheiten (4), die jeweils mindestens zwei Antriebseinheiten (4) umfassen,
wobei die Antriebseinheiten (4) umfangsartig an der Basis (2) und zwischen dieser und dem Rotor (3) angeordnet sind, und jede Antriebseinheit (4) zwei V-förmig zueinander angeordnete auslenkbare Aktoren (5) und ein mit beiden Aktoren verbundenes Friktionselement (6) aufweist, und
wobei eine kontinuierliche Bewegung des Rotors (3) durch phasenversetzte Ansteuerung der Aktoren (5) unterschiedlicher Gruppen (40, 42) von Antriebseinheiten (4) realisiert ist,
**dadurch gekennzeichnet, dass**
der Rotor (3) und die Friktionselemente (6) mittels einer zwischen den Antriebseinheiten (4) und im Innenumfang des Rotors angeordneten Federeinrichtung (30) in einer Richtung aufeinander derart unter Druck konfiguriert sind, dass bei unausgelenktem Zustand der Aktoren (5) alle Friktionselemente (6) in Kontakt mit dem Rotor (3) stehen und gemeinsam eine Kontaktebene (K) aufspannen, und dass die insgesamt vorgesehenen Antriebseinheiten (4) der Gruppen (40, 42) von Antriebseinheiten (4) entlang eines Kreisumfangs angeordnet sind.

2. Rotationsverstellvorrichtung (1) nach Anspruch 1, **dadurch gekennzeichnet, dass** die Federeinrichtung (30) einstückig mit dem Rotor (3) ausgebildet ist.

3. Rotationsstellvorrichtung (1) nach Anspruch 1 oder 2, **dadurch gekennzeichnet, dass** die Federeinrichtung (30) schlitzförmige Ausnehmungen (32) aufweist.

4. Rotationsstellvorrichtung (1) nach einem der vorhergehenden Ansprüche, **dadurch gekennzeichnet, dass** sich die Aktoren (5) an der Basis (2) jeweils über einen Stützabschnitt (20) abstützen, der über ein Gelenk mit der Basis (2) verbunden ist.

5. Rotationsstellvorrichtung (1) nach einem der vorhergehenden Ansprüche, **dadurch gekennzeichnet, dass** der Rotor (3) eine Friktionsscheibe (34) umfasst, die zum Kontakt mit den Friktionselementen (6) vorgesehen ist.

6. Rotationsstellvorrichtung (1) nach einem der vorhergehenden Ansprüche, **dadurch gekennzeichnet, dass** mit dem Rotor (3) einstückig ein Schaft (34) ausgebildet ist, der durch die Basis (2) hindurchragt, wobei der Schaft (34) dafür vorgesehen ist, ein durch die Rotationsstellvorrichtung (1) zu positionierendes Element daran anzubringen.

7. Rotationsstellvorrichtung (1) nach einem der vorhergehenden Ansprüche, **dadurch gekennzeichnet, dass** die Aktoren (5) ein elektromechanisches Material aufweisen und vorzugsweise daraus bestehen.

8. Rotationsstellvorrichtung (1) nach Anspruch 7, **dadurch gekennzeichnet, dass** die Aktoren (5) aus piezoelektrischem und bevorzugt aus piezokeramischem Material bestehen.

9. Verfahren zum Betreiben der Rotationsstellvorrichtung (1) nach einem der vorhergehenden Ansprüche, wobei unterschiedliche Gruppen (40, 42) von Antriebseinheiten (4) phasenversetzt zueinander angesteuert werden.

10. Verfahren zum Betreiben der Rotationsstellvorrichtung (1) nach Anspruch 9, **dadurch gekennzeichnet, dass** die Ansteuerung der jeweiligen Gruppe (40, 42) von Antriebseinheiten (4) eine definierte Bewegungsbahn der diesen Antriebseinheiten (4) zugeordneten Friktionselemente (6) bewirkt, die eine im Wesentlichen senkrecht zur Kontaktebene (K) angeordnete vertikale Bewegungskomponente und eine im Wesentlichen parallel zur Kontaktebene (K) angeordnete horizontale Bewegungskomponente aufweist, und aufgrund der vertikalen Bewegungskomponente, die gegen die Kraft der Federeinrichtung (30) wirkt, ein Außerkontaktbringen der Friktionselemente (6) der Aktoren (5) der jeweils anderen Gruppe von Antriebseinheiten (4) von dem Rotor (3) und aufgrund der horizontalen Bewegungskomponente eine Generierung eines definierten Antriebsschritts des Rotors (3) in Antriebsrichtung resultiert.

## Claims

1. Rotation actuating device (1), comprising:
a base (2),
a rotor (3), and
at least two groups (40, 42) of drive units (4) which each comprise at least two drive units (4),
wherein the drive units (4) are arranged circumferentially on the base (2) and between the latter and the rotor (3), and wherein each drive unit (4) comprises two deflectable actuators (5) arranged in a V-shape with respect to one another and a friction element (6) which is connected to both actuators, and
wherein a continuous movement of the rotor (3) is realized by means of phase-offset actuation of the actuators (5) of different groups (40, 42) of drive units (4),
**characterized in that**
the rotor (3) and the friction elements (6) are configured under pressure in a direction towards each other by means of a spring device (30) which is arranged between the drive units (4) and in the inner circumference of the rotor such that, when the actuators (5) are not deflected, all the friction elements (6) are in contact with the rotor (3) and together span a contact plane (K) and that the drive units (4) of the groups (40, 42) of drive units (4), which are provided as a whole, are arranged along a circumference of a circle.

2. Rotation actuating device (1) according to claim 1, **characterized in that** the spring device (30) is formed in one piece with the rotor (3).

3. Rotation actuating device (1) according to claim1 or 2, **characterized in that** the spring device (30) comprises slit-shaped recesses (32).

4. Rotation actuating device (1) according to one of the preceding claims, **characterized in that** the actuators (5) are each supported on the base (2) via a support section (20) which is connected to the base (2) via a joint.

5. Rotation actuating device (1) according to one of the preceding claims, **characterized in that** the rotor (3) comprises a friction disc (34) which is provided for contact with the friction elements (6).

6. Rotation actuating device (1) according to one of the preceding claims, **characterized in that** a shaft (34) is formed in one piece with the rotor (3) and projects through the base (2), wherein the shaft (34) is provided for attaching an element to be positioned by the rotation adjusting device (1) thereto.

7. Rotation actuating device (1) according to any one of the preceding claims, **characterized in that** the actuators (5) comprise an electromechanical material and preferably consist thereof.

8. Rotation actuating device (1) according to claim 7, **characterized in that** the actuators (5) consist of piezoelectric and preferably of piezoceramic material.

9. Method for operating the rotation actuating device (1) according to one of the preceding claims, wherein different groups (40, 42) of drive units (4) are controlled in a phase-offset manner with respect to one another.

10. Method for operating the rotation actuating device (1) according to claim 9, **characterized in that** the control of the respective group (40, 42) of drive units (4) effects a defined movement path of the friction elements (6) associated with these drive units (4), which comprises a vertical movement component arranged substantially perpendicular to the contact plane (K) and a horizontal movement component arranged substantially parallel to the contact plane (K), and due to the vertical movement component, which acts against the force of the spring device (30), a bringing the friction elements (6) of the actuators (5) of the respective other group of drive units (4) out of contact with the rotor (3) and due to the horizontal movement component a generation of a defined drive step of the rotor (3) in the drive direction results.

## Revendications

1. Dispositif de réglage rotatif (1) comprenant :
une base (2),
un rotor (3), et
au moins deux groupes (40, 42) d'unités d'entraînement (4), comprenant chacun au moins deux unités d'entraînement (4),
dans lequel les unités d'entraînement (4) sont disposées de manière circonférentielle sur la base (2) et entre celle-ci et le rotor (3), et chaque unité d'entraînement (4) comprend deux actionneurs (5) configurés pour pouvoir être déviés, disposés en V l'un par rapport à l'autre, et un élément de friction (6) relié aux deux actionneurs, et
dans lequel un mouvement continu du rotor (3) est réalisé par une commande déphasée des actionneurs (5) de différents groupes (40, 42) d'unités d'entraînement (4),
**caractérisé en ce que**
le rotor (3) et les actionneurs (6) sont configurés sous pression l'un par rapport à l'autre dans une direction au moyen d'un dispositif à ressort (30) disposé entre les unités d'entraînement (4) et dans la périphérie intérieure du rotor de telle sorte que, lorsque les actionneurs (5) ne sont pas déviés, tous les éléments de friction (6) sont en contact avec le rotor (3) et définissent ensemble un plan de contact (K), et **en ce que** les unités d'entraînement (4) des groupes (40, 42) d'unités d'entraînement (4) prévues dans leur ensemble sont disposées le long d'une circonférence.

2. Dispositif à ressort (1) selon la revendication 1, **caractérisé en ce que** le dispositif à ressort (30) est formé d'une seule pièce avec le rotor (3).

3. Dispositif de réglage rotatif (1) selon la revendication 1 ou 2, **caractérisé en ce que** le dispositif à ressort (30) comporte des évidements (32) en forme de fentes.

4. Dispositif de réglage rotatif (1) selon l'une des revendications précédentes, **caractérisé en ce que** les actionneurs (5) s'appuient chacun sur la base (2) par l'intermédiaire d'une portion d'appui (20) reliée à la base (2) par une articulation.

5. Dispositif de réglage rotatif (1) selon l'une des revendications précédentes, **caractérisé en ce que** le rotor (3) comprend un disque de friction (34) prévu pour être en contact avec les éléments de friction (6).

6. Dispositif de réglage rotatif (1) selon l'une des revendications précédentes, **caractérisé en ce qu'**une tige (34) est formée d'un seul tenant avec le rotor (3) et traverse la base (2), ladite tige (34) étant destinée à y monter un élément à positionner par le dispositif de réglage rotatif (1).

7. Dispositif de réglage rotatif (1) selon l'une des revendications précédentes, **caractérisé en ce que** les actionneurs (5) comportent, et de préférence sont constitués, d'un matériau électromécanique.

8. Dispositif de réglage rotatif (1) selon la revendication 7, **caractérisé en ce que** les actionneurs (5) sont constitués d'un matériau piézoélectrique et de préférence d'un matériau piézocéramique.

9. Procédé de mise en oeuvre du dispositif de réglage rotatif (1) selon l'une des revendications précédentes, dans lequel différents groupes (40, 42) d'unités d'entraînement (4) sont commandés de manière déphasée les uns par rapport aux autres.

10. Procédé pour faire fonctionner le dispositif de réglage rotatif (1) selon la revendication 9, **caractérisé en ce que** la commande du groupe respectif (40, 42) d'unités d'entraînement (4) provoque une trajectoire de mouvement définie des éléments de friction (6) associés à ces unités d'entraînement (4), qui présente une composante de mouvement verticale disposée essentiellement perpendiculairement au plan de contact (K) et une composante de mouvement horizontale disposée essentiellement parallèlement au plan de contact (K), et, en raison de la composante de mouvement verticale qui agit contre la force du dispositif à ressort (30), il en résulte une mise hors de contact du rotor (3) des éléments de friction (6) des actionneurs (5) de l'autre groupe respectif d'unités d'entraînement (4) et, en raison de la composante de mouvement horizontale, une génération d'un pas d'entraînement défini du rotor (3) dans la direction d'entraînement.
